# DEMANDE DE BREVET EUROPEEN

(11) **EP 4 572 595 A1**
(43) Date de publication de la demande: **18.06.2025**
(21) Numéro de dépôt: 24307084.4
(22) Date de dépôt: 12.12.2024
(51) Int. Cl.: H10N 70/20, H10B 63/10

(54) **CIRCUIT INTÉGRÉ COMPRENANT UNE MÉMOIRE NON VOLATILE ET PROCÉDÉ DE FABRICATION ASSOCIÉ**

(30) Priorité: 14.12.2023 FR 2314206
(71) Demandeur: Commissariat à l'Energie Atomique et aux Energies Alternatives, 75015 Paris (FR)
(72) Inventeur: BOURGEOIS, Guillaume, 38054 GRENOBLE CEDEX 09 (FR); DORY, Jean-Baptiste, 38054 GRENOBLE CEDEX 09 (FR); MINGUET LOPEZ, Joël, 38054 GRENOBLE CEDEX 09 (FR); NAVARRO, Gabriele, 38054 GRENOBLE CEDEX 09 (FR)
(74) Mandataire: Cabinet Camus Lebkiri

(57) **Abrégé**

Un aspect de l'invention concerne un circuit intégré (1) comprenant :
- un via (42) en cuivre ; et
- une mémoire non volatile (5), électriquement connectée au via (42) en cuivre,
le circuit intégré est remarquable en ce qu'il comprend une barrière de diffusion (6) au cuivre, à base de Ta, Ti ou Co, s'étendant sous forme de couche contre sur le via en cuivre, la mémoire non volatile étant connectée au via par l'intermédiaire de la barrière de diffusion.

## Description

### DOMAINE TECHNIQUE DE L'INVENTION

Le domaine technique de l'invention concerne les circuits intégrés comprenant des mémoires non volatiles et mettant plus particulièrement en oeuvre un matériau à changement de phase, dite mémoire PCM pour « Phase Change Material » en anglais. Le domaine technique concerne par exemple les circuits intégrés pouvant être mis en oeuvre dans le domaine automobile.

### ARRIÈRE-PLAN TECHNOLOGIQUE DE L'INVENTION

Une mémoire non volatile mettant en oeuvre un matériau à changement de phase (dit « PCM » pour « Phase Change Material » en anglais ») peut être caractérisée par sa résistance, celle-ci pouvant prendre au moins deux valeurs distinctes. Chaque valeur de résistance correspond à un état distinct que peut prendre la mémoire, permettant ainsi de stocker une information binaire. Une valeur élevée de résistance correspond à un état dit « RESET », généralement associé à un état bas ou « 0 ». Une valeur faible de résistance correspond à un état dit « SET », généralement associé à un état haut ou « 1 ».

La programmation de la mémoire d'un état à l'autre, ou d'une valeur de résistance à une autre, peut être réalisée suivant les étapes dites de programmation « RESET » ou programmation « SET ».

La programmation « RESET », se base sur la fonte de la totalité ou d'une partie du volume du matériau à changement de phase (par exemple un chalcogénure) qui est atteinte par une impulsion électrique avec un courant suffisamment important. Le courant est dimensionné pour permettre d'atteindre une température de fusion du matériau PCM par effet Joule. Un refroidissement soudain, obtenu grâce à une réduction rapide du courant appliqué, permet de laisser la partie fondue du matériau PCM dans un état amorphe. Cet arrange amorphe présente une résistance élevée, correspondant à l'état RESET.

La programmation « SET », se base sur l'obtention d'un état cristallin du matériau PCM. Cette opération consiste à appliquer une impulsion électrique qui produit, par effet Joule, une fonte partielle ou totale du matériau PCM. Une réduction graduelle du courant appliqué permet de recristalliser le matériau PCM. Cet état cristallin, présentant une résistance moindre, correspond à l'état SET.

La rétention d'information peut être caractérisée par la durée de maintien de l'état RESET en fonction du temps et de la température. Les spécifications en termes de rétention de l'information peuvent être strictes pour des applications embarquées. Par exemple, une norme dite « JEDEC », appliquée à l'automobile, impose une stabilité de l'état RESET de deux ans à une température de 150°C.

Le document [« Optimization Metrics for Phase Change Memory (PCM) Cell Architectures », M. Boniardi & al., IEDM14 IEEE 2014] divulgue une mémoire non volatile comprenant une couche de matériau PCM et une chaufferette (également appelé « heater » en anglais) connectée en série. La chaufferette est notamment de type « WALL », c'est-à-dire présentant une forme d'ailette, s'étendant perpendiculairement au plan des couches. Ainsi, le contact entre la couche PCM et la chaufferette est de faible dimension, permettant d'atteindre des densités de courant élevées au point de contact. Les températures accessibles avec ce type de chaufferette permettent d'améliorer l'efficacité de programmation de la couche PCM. Le document divulgue également que l'ensemble couche PCM/chaufferette est connecté en série entre deux électrodes métalliques, en l'occurrence en tungstène. L'application d'un potentiel électrique aux bornes des électrodes en tungstène provoque la circulation d'un courant électrique qui, par effet Joule dans la chaufferette résistive, provoque un échauffement localisé de la couche PCM.

Le document [« High Density Embedded PCM in 28 nm FDSOI Tecnology for Automotive Micro-Controller Applications », F. Arnaud & al., IEDM20 IEEE 2020] divulgue une mémoire non volatile intégrée dans un circuit intégré, comprenant une couche PCM mutualisée entre plusieurs éléments chauffants, dites « chaufferettes » de type WALL. Chaque élément chauffant est connecté en série avec une électrode, distincte pour chaque élément chauffant, et la couche PCM. Cet agencement des mémoires permet de les rapprocher du « bloc fonctionnel de fin de ligne » du circuit intégré, encore appelé « Niveau secondaire de fabrication » ou « BEOL » pour « Back-end of Line » en anglais, en les disposant sous un premier niveau de routage. De la sorte, les mémoires non volatiles peuvent être séparées du « bloc fonctionnel de début de ligne » du circuit intégré, encore appelé « Niveau primaire de fabrication » ou « FEOL » pour « Front-end of Line » en anglais, dans lequel des circuits logiques, par exemple de type « CMOS » (pour « Complementary Metal Oxide Semiconductor ») sont intégrés.

La connexion électrique entre les différents niveaux du circuit intégré, c'est-à-dire entre les circuits logiques du FEOL et les mémoires des différents niveaux du BEOL, est réalisée au moyen de niveaux de routage comprenant des vias en cuivre, traversant les différents niveaux du circuit. L'intégration de couche PCM au voisinage de vias en cuivre est toutefois problématique. En effet, le cuivre est un élément pouvant dégrader les couches PCM. De plus, la diffusion du cuivre peut être assistée par la température. Ainsi, la fabrication des mémoires ou la circulation de courant dans les éléments chauffants assiste la diffusion de cuivre et peut provoquer la dégradation des couches PCM. Il existe donc un besoin d'intégrer une couche PCM au niveau du BEOL tout en évitant les écueils liés à la diffusion du cuivre.

Dans cet optique, le document [« 18 nm FDSOI Technology Platform embedding PCM & Innovative Continuous-Active Construct Enhancing Performance for Leading-Edge MCU Application », D. Min & al., IEDM21 IEEE 2021] divulgue également une mémoire non volatile intégrée dans un circuit intégré, comprenant une couche PCM mutualisée entre plusieurs éléments chauffants de type WALL. Chaque élément chauffant est, ici, connecté en série entre un contact en tungstène appelé couche tampon ou « plug » en anglais et la couche PCM.

Toutefois, la formation de la couche tampon implique plusieurs étapes de fabrication. De plus, son épaisseur importante pose des problèmes d'intégration dans le BEOL où l'épaisseur entre les différents niveaux, au sein d'un circuit intégré, peut être contrainte.

### RÉSUME DE L'INVENTION

Il existe un besoin de fournir un circuit intégré visant à résoudre, au moins partiellement, les problèmes précités. Pour cela, l'invention offre un moyen de bloquer la diffusion de cuivre entre un niveau de routage et une mémoire pouvant être impactée par la diffusion de cuivre, présentant une épaisseur faible et dont la fabrication est simple.

L'invention concerne plus particulièrement un circuit intégré comprenant :
- un substrat présentant une surface plane ;
- au moins un via ou une ligne, en cuivre, s'étendant dans le substrat et débouchant sur la surface plane du substrat en exposant une surface dite « surface de contact » ;
- au moins une mémoire non volatile comprenant :
   - une première électrode, dite « élément chauffant » ;
   - une deuxième électrode, dite « électrode supérieure » ; et
   - une première couche active entre l'élément chauffant et l'électrode supérieure, électriquement connectée à l'électrode supérieure et à l'élément chauffant,
le circuit intégré étant remarquable en ce qu'il comprend au moins une barrière de diffusion au cuivre à base de tantale ou de titane ou de cobalt ou de leurs alliages, ladite au moins une barrière de diffusion s'étendant sous forme de couche contre au moins une partie de la surface de contact dudit au moins un via ou de ladite au moins une ligne, l'élément chauffant de ladite au moins une mémoire non volatile étant en contact avec la première couche active de ladite au moins une mémoire non volatile et en contact avec ladite au moins une barrière de diffusion.

Par surface plane, on entend une surface s'étendant dans un plan (par exemple un plan horizontal).

Par via, on entend une piste conductrice s'étendant dans le substrat par exemple selon une direction perpendiculaire à la surface du substrat. Par ligne, on entend une piste conductrice s'étendant dans le substrat, par exemple selon une direction parallèle à la surface du substrat.

Par « couche active », on entend une couche dont la résistance peut varier, de manière réversible ou irréversible, suite à la circulation d'un courant ou l'application d'un traitement thermique. Préférentiellement, la première couche active peut changer de résistance entre au moins deux valeurs distinctes, de manière bistable, permettant de stocker une information.

Par mémoire non volatile, on entend préférentiellement une mémoire à changement de phase.

Par « parallèle » et « perpendiculaire », on entend respectivement parallèle à 20º près, voire parallèle à 10º près, et perpendiculaire à 20º près, voire perpendiculaire à 10º près.

Par « à base d'un élément », on entend préférentiellement comprenant au moins 50 % de cet élément.

Par « en contact » est entendu qu'il n'y d'élément intermédiaire entre les éléments en contact. Typiquement, il n'y a pas de couche intermédiaire entre deux éléments en contact, notamment entre l'élément chauffant et la première couche active, ni entre la mémoire volatile et la barrière de diffusion.

Chaque couche barrière empêche la diffusion du cuivre vers la mémoire et/ou vers l'élément chauffant pendant la fabrication du circuit intégré ou pendant son utilisation. Cette couche remplace l'utilisation d'une couche tampon en tungstène.

La barrière de diffusion permet de fabriquer la mémoire non volatile au niveau du BEOL du circuit intégré et donc d'éloigner cette dernière des circuits logiques du FEOL du circuit intégré. Cet agencement permet d'éviter que les mémoires non volatiles ne puissent perturber le fonctionnement des circuits logiques du FEOL.

De plus, les matériaux à base de Ta, Ti, Co sont suffisamment efficaces pour bloquer la diffusion de cuivre tout en permettant de réaliser une barrière de diffusion sous forme de couche présentant une faible épaisseur. Ainsi, contrairement à une couche tampon en tungstène, qui présente une épaisseur importante, les barrières de diffusion selon l'invention permettent de réduire significativement la hauteur totale de chaque mémoire non volatile. Les barrières à base de Ta, Ti ou Co offrent une intégration plus aisée des mémoires non volatiles. Elles offrent la possibilité d'utiliser le circuit intégré résultant à plus haute fréquence. En effet, la hauteur entre les différents niveaux du BEOL peut être contrainte par la hauteur des mémoires non-volatiles. Réduire la hauteur des mémoires permet de réduire l'épaisseur entre les différents niveaux du BEOL. La longueur des vias en cuivre connectant ces niveaux peut alors également être réduire. Ainsi, la résistance de chaque via et le couplage capacitif entre les vias diminuent, permettant une utilisation du circuit à plus haute fréquence.

Les barrières de diffusion peuvent être mise en oeuvre à différents niveaux du circuit intégré, par exemple au plus proche du FEOL.

Avantageusement, pour chaque mémoire non volatile, chaque élément chauffant comprend une portion, dite « ailette », s'étendant perpendiculairement à la surface du substrat et comprenant une première extrémité, en contact avec la première couche active de ladite mémoire non volatile, et une deuxième extrémité, en contact avec ladite au moins une barrière de diffusion.

Avantageusement, chaque barrière de diffusion s'étend contre la totalité de la surface de contact d'un via ou de ladite au moins une ligne en cuivre. Ainsi, le blocage de la diffusion est amélioré. Ceci permet également d'éviter le recours à une solution complémentaire pour réduire la diffusion du cuivre à partir d'une portion de la surface de contact de chaque via ou ligne qui ne serait pas couverte par la barrière de diffusion. Selon un développement, chaque barrière de diffusion s'étend au-delà de ladite surface de contact en s'étendant également sur la surface plane du substrat.

Avantageusement, chaque élément chauffant comprend un matériau parmi : TiN, TiC, TiSiN, TiSiCN, TiWN, TaN et TaCN.

Avantageusement, la première couche active de chaque mémoire volatile comprend un matériau chalcogénure. Ainsi la première couche est programmable.

Selon un mode de réalisation, le circuit intégré comprend :
- une pluralité de mémoires non volatiles ; et
- une pluralité de barrières de diffusion, distantes les unes des autres ;
- une pluralité de vias en cuivre ou de lignes en cuivre, chaque via ou ligne s'étendant dans le substrat et débouchant sur la surface du substrat en exposant une surface de contact, lesdites surfaces de contact étant agencées selon une matrice,
chaque barrière de diffusion s'étendant sous forme de couche contre au moins une partie de la surface de contact d'un des vias ou d'une des lignes, l'élément chauffant de chaque mémoire non volatile étant connecté à l'une des barrières de diffusion.

Avantageusement, les premières couches actives des différentes mémoires non volatiles sont isolées latéralement les unes des autres. Par « isolées latéralement », on entend que les premières couches actives sont sans contact direct.

Selon un mode de réalisation alternatif, une même première couche active est continue et commune à au moins deux mémoires non-volatiles, ladite même première couche active étant en contact avec chaque élément chauffant desdites au moins deux mémoires non-volatiles. Les premières couches actives peuvent ainsi être mutualisées entre plusieurs mémoires non volatiles. Ceci permet par exemple de réduire le nombre d'opérations pour réaliser les premières couches actives, en particulier le nombre de gravure.

Selon un mode de réalisation, le circuit intégré comprend un élément de sélection associé à ladite au moins une mémoire non volatile. Il permet un adressage de chaque mémoire. Cette configuration permet de disposer d'un sélecteur dans le BEOL, avec chaque mémoire. Cet agencement permet de s'affranchir de l'utilisation d'un composant logique, par exemple un transistor CMOS du FEOL en tant que sélecteur. Cet agencement permet ainsi de s'affranchir de la technologie mise en oeuvre dans le FEOL et rend chaque mémoire portable.

Avantageusement, l'élément de sélection est un commutateur ovonique à seuil dit « OTS », comprenant préférentiellement un alliage à base de Ge, Sb, Se, As, Si, Te, S ou Al, pouvant être dopé, tel que les alliages de GeSbSe, GeSe, AsSeSiGe, AsSe, SbSe, SiSe, AsTe, SiGeSe ou de AlTe.

Avantageusement, le circuit intégré est dépourvu de via en tungstène ou de via métallique en contact avec ledit au moins un via en cuivre ou ladite au moins une ligne en cuivre et l'élément chauffant de ladite au moins une mémoire non volatile.

Avantageusement, l'au moins une barrière de diffusion est un bicouche planaire, le bicouche planaire comprenant du TaN en contact avec le via ou la ligne, et comprenant du Ta en contact de l'élément chauffant.

L'invention concerne également un procédé de fabrication d'un circuit intégré comprenant les étapes de :
- fournir :
   - un substrat présentant une surface plane ; et
   - au moins un via ou au moins une ligne, en cuivre, s'étendant dans le substrat et débouchant sur la surface plane du substrat en exposant une surface dite « surface de contact »,
- former au moins une barrière de diffusion au cuivre à base de tantale ou de titane ou de cobalt ou de leurs alliages, de sorte que ladite au moins une barrière de diffusion s'étende sous forme de couche contre au moins une partie de la surface de contact dudit au moins un via ou de ladite au moins une ligne ;
- former au moins une mémoire non volatile comprenant :
   - une première électrode, dite « élément chauffant », étant en contact avec ladite au moins une barrière de diffusion ;
   - une deuxième électrode, dite « électrode supérieure » ; et
   - une première couche active entre l'élément chauffant et l'électrode supérieure, électriquement connectée à l'électrode supérieure et en contact avec l'élément chauffant.

La formation d'un tampon, par exemple en tungstène, nécessite cinq étapes supplémentaires, comprenant notamment une étape de polissage chimico-physique. La formation des barrières de diffusion nécessite au plus deux étapes (par exemple le dépôt d'une couche et sa délimitation). Le nombre et la complexité des étapes sont réduits.

Selon un mode de réalisation, la fabrication de chaque barrière de diffusion comprend l'étape de faire croître ladite barrière de diffusion par dépôt sélectif de tantale ou de titane ou de cobalt ou de leurs alliages sur la surface de contact d'un via en cuivre ou d'une ligne en cuivre.

Ainsi la croissance par dépôt sélectif permet de localiser la croissance des barrières de diffusion au niveau de la surface de contact des via ou des lignes en cuivre.

Selon une variante d'implémentation, la fabrication de la barrière de diffusion comprend les étapes de :
- déposer une couche à base de tantale ou de titane ou de cobalt ou de leurs alliages, dite « couche en matériau barrière », sur la surface plane du substrat et la surface de contact dudit au moins un via ou de ladite au moins une ligne en cuivre ;
- graver la couche en matériau barrière à travers au moins un masque de gravure, avec arrêt sur le substrat, de manière à former l'au moins une barrière de diffusion.

Avantageusement, pour former une pluralité de barrières de diffusion, la gravure de la couche en matériau barrière est réalisée de manière à former des barrières de diffusion séparées les unes des autres.

Avantageusement, la gravure de la couche en matériau barrière à travers ledit au moins un masque est réalisé de sorte que chaque barrière de diffusion s'étendant sous forme de couche contre au moins une partie de la surface de contact dudit au moins un via ou de ladite au moins une ligne.

Avantageusement, la formation de chaque mémoire non volatile comprend les étapes de :
- former, avant l'étape de gravure de la couche en matériau barrière, une première couche diélectrique s'étendant sur la couche en matériau barrière, laissant libre au moins une portion de la couche en matériau barrière, ladite première couche diélectrique comprenant au moins un flanc s'étendant perpendiculairement à la surface plane du substrat, à l'aplomb de la surface de contact dudit au moins un via ou de ladite au moins une ligne ;
- déposer une couche résistive de manière conforme sur la première couche diélectrique et sur ladite au moins une portion libre de la couche en matériau barrière ;
- graver la couche résistive de manière anisotrope, perpendiculairement à la surface plane du substrat, avec arrêt sur la couche en matériau barrière, de manière à laisser une portion de la couche résistive, dite « ailette », s'étendant perpendiculairement à la surface plane du substrat, depuis la couche en matériau barrière, contre le flanc de la première couche diélectrique et à l'aplomb de la surface de contact dudit au moins un via ou de ladite au moins une ligne ;
- graver la couche en matériau barrière de manière anisotrope à travers un premier masque de gravure, avec arrêt sur le substrat, le premier masque de gravure comprenant la première couche diélectrique et l'ailette ;
- graver l'ailette et la couche en matériau barrière de manière anisotrope à travers un deuxième masque de gravure, avec arrêt sur le substrat, de manière à délimiter chaque barrière de diffusion à partir de la couche en matériau barrière, au niveau d'une partie de la surface de contact dudit au moins un via ou de ladite au moins une ligne, et de manière à délimiter chaque première électrode, dite « élément chauffant », à partir de l'ailette, dans le prolongement d'une barrière de diffusion.

Le dépôt conforme de la couche résistive sur la première couche diélectrique permet de former une couche résistive présentant des portions parallèles au substrat et une portion perpendiculaire au substrat. Les portions parallèles de la couche résistive sont retirées par la gravure. La portion perpendiculaire de la couche résistive est conservée car elle présente une épaisseur, mesurée perpendiculairement au substrat, beaucoup plus important que les portions parallèles. Cette portion perpendiculaire forme ainsi l'ailette.

Le premier masque de gravure et l'ailette s'étendant contre le flanc de la première couche diélectrique forme alors un premier masque de gravure protégeant une partie de la couche en matériau barrière de la gravure. Ainsi, l'ailette est au moins en contact avec la partie de la couche en matériau barrière qu'elle protège de la gravure.

La gravure à travers le deuxième masque permet de délimiter chaque barrière de diffusion et chaque élément chauffant dans le prolongement d'un via ou d'une ligne.

Avantageusement, la formation de chaque mémoire non volatile comprend les étapes de :
- déposer, avant la gravure de l'ailette et de la couche en matériau barrière à travers le deuxième masque de gravure, une première couche active s'étendant parallèlement à la surface plane du substrat et au contact de chaque ailette ;
- graver la première couche active à travers le deuxième masque de gravure de manière à délimiter la première couche active dans le prolongement d'un élément chauffant et d'une barrière de diffusion.

Chaque mémoire non volatile comprend ainsi une première couche active alignée avec un élément chauffant. Le couplage entre première couche active et élément chauffant est donc contrôlé et identique pour différentes mémoires non volatiles. Cet alignement permet également de supprimer une dérive spatiale due à plusieurs étapes de gravures réalisées à des niveaux différents. De plus, la mémoire non volatile est également alignée avec une barrière de diffusion, garantissant une protection de la première couche active vis-à-vis du cuivre qui soit efficace.

Avantageusement, lorsque le procédé forme deux mémoires volatiles, le deuxième masque de gravure est configuré pour que les premières couches actives des deux mémoires non volatiles forment une seule et même couche.

Les deux premières couches actives forment par exemple un îlot ou une ligne.

Avantageusement, la formation de chaque mémoire non volatile comprend :
- déposer, avant la gravure de la première couche active à travers le deuxième masque de gravure, une première couche métallique sur la première couche active ;
- graver la première couche métallique à travers le deuxième masque de gravure de manière à délimiter chaque électrode supérieure, dans le prolongement d'un élément chauffant et d'une barrière de diffusion.

Avantageusement, le procédé comprend également l'étape de former un élément de sélection associé à chaque mémoire non volatile, en contact avec l'électrode supérieure de chaque mémoire non volatile.

Avantageusement, l'au moins une barrière de diffusion est gravée une première fois selon une première direction lors de la formation de l'élément chauffant, et une deuxième fois selon une deuxième direction, différente de la première direction, lors de la formation, par exemple par gravure, de l'électrode supérieure.

### BRÈVE DESCRIPTION DES FIGURES

L'invention et ses différentes applications seront mieux comprises à la lecture de la description qui suit et à l'examen des figures qui l'accompagnent. Les figures sont présentées à titre indicatif et nullement limitatif de l'invention.
Les figures 1A, 1B, 2 et 3présentent des premier, deuxième et troisième mode de réalisation d'un circuit intégré selon l'invention. La figure 1B correspond à un agrandissement de la figure 1A.
Les figures 4, 5, 6, 7, 8, 9, 10, 11, 12, 13, 14, 15, 16, 17 et 18 présentent une première mise en oeuvre d'un procédé de fabrication selon l'invention, permettant d'obtenir le circuit intégré des figures 1A et 1B.
Les figures 19, 20, 21 et 22 présentent une deuxième mise en oeuvre du procédé de fabrication selon l'invention, permettant d'obtenir le circuit intégré de la figure 3.
Les figures 23, 24 et 25 présentent une troisième mise en oeuvre du procédé de fabrication selon l'invention, permettant d'obtenir le circuit intégré de la figure 2.

Sauf précision contraire, un même élément apparaissant sur des figures différentes présente une référence unique.

### DESCRIPTION DÉTAILLÉE

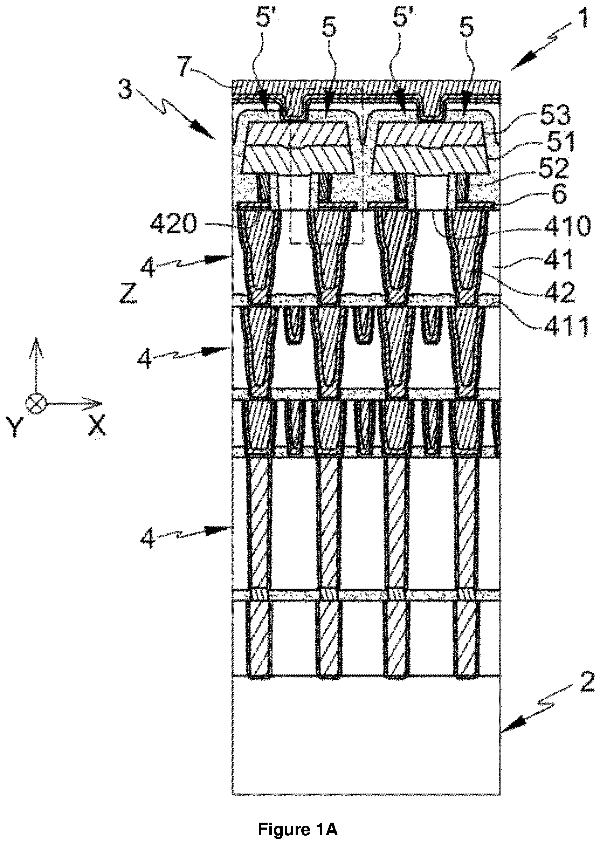

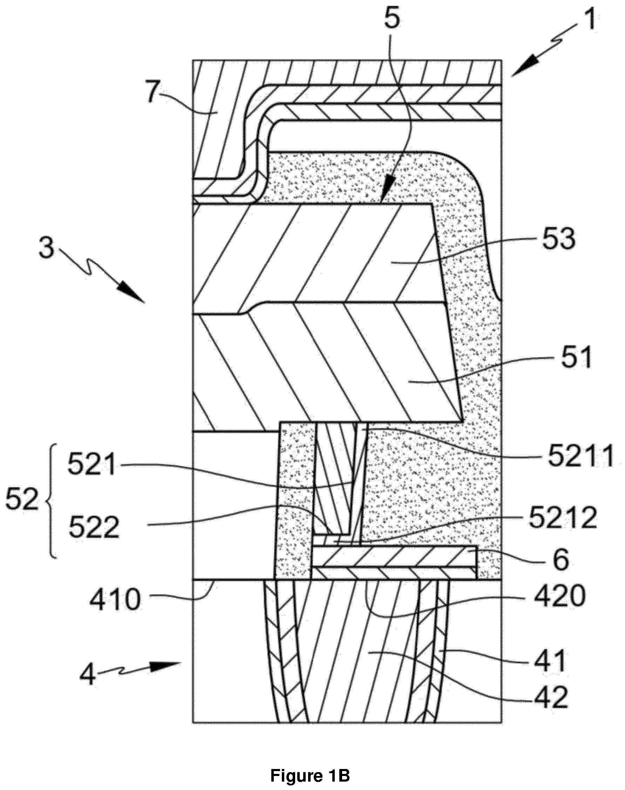

Les figures 1A et 1B présentent un circuit intégré 1 selon un premier mode de réalisation de l'invention. La figure 1B correspond à un agrandissement de la figure 1A matérialisé par un rectangle en traites pointillés. Le circuit 1 comprend deux blocs fonctionnels 2, 3, aussi appelés niveaux fonctionnels, que sont le FEOL 2 (aussi simplement appelé « front-end » ou « FEND ») et le BEOL 3 (aussi simplement appelé « back-end » en anglais). Ce type d'agencement ou d'architecture de circuit intégré est connu de la personne du métier.

Le circuit intégré 1 comprend au moins une mémoire non-volatile 5, 5'. Dans le mode de réalisation des figures 1A et 1B, il comprend deux groupes de deux mémoires non volatiles 5, 5'. Les mémoires 5, 5' sont disposées dans le back-end 3 du circuit 1.

Elles sont connectées électriquement au front-end 2 du circuit 1 par l'intermédiaire d'au moins un niveau de routage cuivre 4, en l'occurrence une pluralité de niveaux 4 dans cette réalisation. Ainsi, les mémoires 5, 5' peuvent être connectées à des composants logiques du front-end 2 jouant par exemple le rôle de sélecteur des différentes mémoires 5, 5'.

Alternativement, les mémoires pourraient également être localisées directement sur le front-end 2 (dans un niveau pouvant être appelé « niveau métallique ») et directement en contact avec les composants logiques du front-end 2.

Dans l'exemple illustré, chaque niveau de routage 4 des figures 1A et 1B comprend un substrat 41 et plusieurs vias 42. Le substrat 41 présente deux surfaces planes 410, 411, opposées l'une à l'autre, dites « surface supérieure » et « surface inférieure ». Elles s'étendent en l'occurrence dans un plan {X ; Y}. Chaque via 42 d'un niveau de routage 4 traverse le substrat 41 de part en part, joignant la surface inférieure 411 du substrat 41 à la surface supérieure 410 du substrat 41. Plus particulièrement, les vias 42 débouchent de chaque surface plane 410, 411 en exposant une surface 420 dite « surface de contact ». Chaque surface de contact 420 des vias 42 est par exemple parallèle et alignée avec les surfaces planes 410, 411 du substrat 41. Par « aligné », on entend aligné à 2 nm près, préférentiellement moins.

Alternativement, le niveau de routage 4 peut comprendre des lignes s'étendant dans le substrat 41 et exposant au moins une surface équivalente à la surface de contact 420 des vias 42. Pour simplifier la description, seul des modes de réalisation présentant des vias 42 seront présentés.

Les surfaces de contact 420 permettent de réaliser un contact électrique avec différents éléments tels qu'un via 42 ou une ligne d'un niveau de routage 4 adjacent, un élément chauffant 52 d'une mémoire 5 ou encore un composant logique du front-end 2.

Les mémoires 5, 5' illustrées dans les figures 1A et 1B comprennent une première couche active 51 permettant de stocker une information. Une couche active 51 permet, grâce à un changement interne, induit par la circulation d'un courant ou un traitement thermique, de montrer une différence de résistance électrique suffisamment importante pour être mesurable et utilisable pour stocker une information.

Dans le cas particulier de l'invention, la première couche active 51 comprend préférentiellement un matériau à changement de phase pour lequel un traitement thermique comprenant un refroidissement plus ou moins bref permet de figer un état cristallin particulier. La couche active comprend un matériau chalcogénure. Il s'agit par exemple d'un alliage de GeₓSb_{y}Te_{z} (avec x + y + z = 100%) tel que Ge₁Sb₂Te₄, GeTe, Sb₂Te₃. L'alliage de GeₓSb_{y}Te_{z} peut également comprendre d'autres éléments d'intérêt comment, par exemple : N, C, O, Si, Se, Bi, In ou encore As.

L'objet de l'invention est pertinent pour un matériau à changement de phase car ces matériaux sont sensibles à la diffusion de cuivre. L'objet de l'invention peut également être étendu à d'autres matériaux actifs pouvant être perturbés ou dégradés par la présence de cuivre. Il s'agit par exemple de :
- matériaux dits « à pont conducteur » (utilisé dans une CBRAM pour ou « Conductive Bridge RAM » en anglais), mettant en oeuvre la formation/dissolution d'un filament conducteur dans un électrolyte solide suite à une diffusion d'ions provenant d'une électrode active ;
- un matériau dit « à claquage réversible d'oxyde » (utilisé dans une OxRAM pour « Oxide RAM » en anglais), mettant en oeuvre le claquage réversible d'un matériau diélectrique en fonction d'une tension électrique appliquée à ce matériau ; ou encore
- un matériau magnétique (utilisé dans une MRAM pour « Magnetic RAM » en anglais), mettant en oeuvre un retournement d'aimantation en fonction de la circulation d'un courant en son sein.

Dans le mode de réalisation des figures 1A et 1B, chaque mémoire 5, 5' comprend une première électrode 52, dite « électrode inférieure », ou « élément chauffant » ou « chaufferette » ou encore « doigt conducteur », connectée électriquement à la première couche active 51. Chaque mémoire 5, 5' comprend également une deuxième électrode 53, dite « électrode supérieure », également connectée électriquement à la première couche active 51. La première couche active 51 est connectée en série entre l'élément chauffant 52 et l'électrode supérieure 53.

Dans ce mode de réalisation, chaque élément chauffant 52 est de type « WALL ». Le principe d'un élément chauffant de ce type et le mode de connexion avec une couche active est décrit dans le document [« Optimization Metrics for Phase Change Memory (PCM) Cell Architectures », M. Boniardi & al., IEDM14, IEEE 2014].

Un élément chauffant 52 de type « WALL » est remarquable en ce qu'il comprend au moins une première portion 521, dite « ailette », s'étendant perpendiculairement à la surface plane 410 du substrat 41 (autrement dit selon une direction Z).

La fabrication d'élément chauffant 52 de type WALL peut fréquemment impliquer la présence d'une deuxième portion 522, dite « pied d'élément chauffant » ou simplement « pied », consécutif de l'ailette 521 et s'étendant parallèlement à la surface plane 410 du substrat 41 (autrement dit dans le plan {X ; Y}). Le pied 522 est préférentiellement absent, afin de pouvoir rapprocher les mémoires 5, 5' et augmenter la densité de stockage d'information par unité de surface.

Chaque élément chauffant 52 peut être réalisé à partir d'un matériau résistif parmi : TiN, TiC, TiSiN, TiSiCN, TiWN, TaN et TaCN.

La première couche active 51 est connectée sur une des extrémités 5211 de l'ailette 521. Ce contact de faible dimension améliore l'efficacité du traitement thermique pouvant être appliqué à la première couche active 51. Il permet de réaliser la programmation de cette couche 51 avec une consommation énergétique réduite.

Le pied 522 de l'élément chauffant 52 est électriquement connecté, d'une part, à une surface de contact d'un via 42 d'un niveau de routage 4 (mais pas directement en contact avec cette surface 420) et d'autre part à une deuxième extrémité 5212 de l'ailette 521.

Les vias 42 des niveaux de routage 4 des figures 1A et 1B sont en cuivre. Le circuit 1 est remarquable en ce qu'il comprend une pluralité de barrière de diffusion 6 au cuivre. Chaque barrière 6 s'étend sous forme de couche fine, contre la surface de contact 420 d'un via 42 en cuivre. Ainsi, la diffusion du cuivre vers les mémoires non volatiles 5, 5' est bloquée.

Il est possible qu'une ou plusieurs, voire toutes, les barrières de diffusion soient de forme planaire, voire totalement de forme planaire. Ceci permet de limiter, voire d'éviter, un encombrement selon la direction Z, tout en évitant que la couche barrière ne contourne l'élément chauffant ou de devoir prévoir des espaceurs. Le plan dans lequel est formé ces barrières de diffusion peut être un plan horizontal (i.e., dans le plan XY) ou un plan vertical (i.e., orthogonal au plan XY).

À la différence d'un tampon en tungstène, tel que mis en oeuvre dans l'art antérieure, chaque barrière de diffusion 6 est réalisée à partir de tantale ou de titane ou de cobalt ou de leurs alliages. Lesdits alliages sont par exemple : TaN/Ta, TiN, TiC, TiSiN, TiSiCN, TaN ou encore TaCN. Lesdits alliages peuvent également comprendre du tungstène, tels que TiWN. Les barrières à base de tantale ou de titane ou de cobalt ou de leurs alliages matériaux offrent une bonne capacité de blocage à la diffusion des atomes de cuivre même avec une épaisseur limitée. Il est donc possible de former des barrières de diffusion 6 sous forme des couches très fines, beaucoup plus fines qu'un tampon en tungstène selon l'art antérieur. De plus, les tampons en tungstène peuvent présenter une rugosité conséquente, pouvant nécessiter un polissage chimique et/ou mécanique. Les barrières de diffusion 6 quant à elles, peuvent présenter une épaisseur, mesurée perpendiculairement à la surface supérieure 410 du substrat, comprise entre 0,5 nm et 20 nm. Par exemple, une barrière 6 de TaN/Ta peut présenter une épaisseur de 13 nm.

Certains matériaux nécessitent de former plusieurs couches afin de former une barrière 6 efficace. Par exemple pour le TaN/Ta, le dépôt d'une couche de TaN sur le cuivre permet de faire croître une couche de Ta dans une phase cristalline adaptée. Par exemple, chaque barrière de diffusion 6 est un bicouche planaire tel que le bicouche planaire comprend du TaN en contact avec le via 42 ou la ligne, et comprend du Ta en contact de l'élément chauffant.

Les barrières de diffusion 6 sont préférentiellement uniquement constituée de TaN/Ta ou de TiN ou de TiC ou de TiSiN ou de TiSiCN ou de TaN ou de TaCN ou de Co, voire de Ta ou de Ti. Elles peuvent également être constituée de TiWN. De la sorte, le blocage de la diffusion du cuivre est amélioré et l'épaisseur des barrières 6 peut être davantage réduite. De manière encore préférée, les barrières de diffusion 6 sont uniquement constituée de TaN/Ta, TiN, TiC, TiSiN, TiSiCN, TaN ou TaCN ou encore de TiWN. Ces matériaux montrent les meilleures capacités de blocage et permettent donc de fabriquer les couches les plus fines.

Selon une variante de réalisation, chaque barrière de diffusion 6 peut comprendre du cobalt Co. En effet, ce dernier peut être lié à du tungstène ou du phosphore pour améliorer ses qualités de barrière au cuivre. Alternativement, chaque barrière de diffusion n'est constituée que de Co. Le cobalt offre également une bonne capacité de blocage à la diffusion des atomes de cuivre même avec une épaisseur limitée. L'intérêt des matériaux tels que le cobalt réside dans la fabrication des barrières de diffusion 6 qui peut être facilitée. En effet, les surfaces de contact 420 en cuivre des vias 42 (ou des lignes) permettent de réaliser un dépôt sélectif par rapport au substrat et obtenir ainsi une croissance de couches au niveau desdites surfaces de contact 420. Les barrières de diffusion 6 ainsi obtenues sont alignées sur les surfaces de contact 420, sans qu'une étape de gravure ou de délimitation particulière ne soit nécessaire.

D'autres matériaux, à base de tantale ou de titane peuvent également permettre la croissance des barrière 6 sans gravure ni délimitation particulière pour peu que ces matériaux puissent être déposés sur le cuivre de manière sélective par rapport au substrat (par exemple par rapport au diélectrique composant le substrat).

Le blocage de la diffusion de cuivre est optimal lorsque les barrières de diffusion 6 s'étendent sur l'intégralité des surfaces de contact 420. Par exemple, chaque barrière de diffusion 6 peut s'étendre sur l'entièreté de la surface de contact 420 et au-delà, en s'étendant par exemple sur la surface supérieure 410 du substrat 41. Les barrières de diffusion 6 forment ainsi des barrières efficaces.

Alternativement, les barrières de diffusion 6 peuvent ne recouvrir qu'une partie de chaque surface de contact 420 tout en fournissant un blocage suffisant de la diffusion de cuivre. En effet, la diffusion du cuivre dépend de la température considérée et de la durée de vie du circuit intégré 1.

De plus, lorsque les barrières de diffusion 6 ne recouvrent qu'une partie de chaque surface de contact 420, une passivation des portions des surfaces de contact 420 restantes peut être réalisée. De cette manière, le film d'oxyde se formant sur les surfaces 420 restantes complète les barrières de diffusion 6. Une couche de SiN peut par exemple être déposée pour réaliser cette passivation et compléter les barrières 6.

Chaque barrière de diffusion 6 offre une surface exempte de cuivre, sur laquelle une mémoire non volatile 5, 5' peut être connectée. Elle assure donc également le transport électrique entre un via 42 et une mémoire 5, 5'. Pour cela, lorsque le circuit 1 comprend plusieurs barrières de diffusion 6, elles sont avantageusement séparées afin d'éviter la création d'un court-circuit entre deux vias 42 ou deux mémoires 5, 5' distincts.

Dans le mode de réalisation des figures 1A et 1B, chaque mémoire non volatile 5, 5' est connectée à une barrière de diffusion 6 par l'intermédiaire de son élément chauffant 52. En particulier, le pied 522 de chaque élément chauffant 52 s'étend sur une barrière de diffusion 6. Le pied 522 peut permettre de réduire davantage la diffusion du cuivre en formant une surépaisseur sur la barrière de diffusion 6.

Chaque mémoire 5, 5' peut présenter une première couche active 51, distinct des premières couches actives 51 des autres mémoires. Dans le mode de réalisation des figures 1A et 1B, les mémoires 5, 5' sont agencées par groupe de deux. Elles sont notamment particulières en ce que chaque groupe de mémoires 5, 5' présente une première couche active 51 commune. Ainsi chaque première couche active 51 des figures 1A et 1B est en contact électrique avec deux éléments chauffants 52.

Chaque mémoire 5, 5' présente une électrode supérieure 53 s'étendant sur la première couche active 51. Cette électrode supérieure permet de réaliser, avec l'élément chauffant 52, la circulation d'un courant électrique dans la première couche active 51, pour réaliser le traitement thermique de la première couche active 51.

Dans le mode de réalisation des figures 1A et 1B, les mémoires 5, 5' présentent, deux à deux, une première couche active 51 commune et une électrode supérieure 53 commune, s'étendant sur la première couche active 51 commune. Le changement de phase pouvant donner lieu au stockage d'information se situe principalement sur le chemin électrique entre le point de contact avec un élément chauffant 52 et l'électrode supérieure 53. Une distance suffisante entre ces deux chemins électriques permet un fonctionnement indépendant des mémoires 5, 5' partageant une même première couche active 51.

Alternativement, deux électrodes supérieurs 53 distinctes peuvent s'étendre sur une même première couche active 51 afin d'améliorer la séparation des chemins électriques.

Les mémoires 5, 5' des figures 1A et 1B sont électriquement connectées à une piste conductrice 7 s'étendant parallèlement à la surface supérieure 410 du substrat 41 et présentant des protubérances reliant chaque électrode supérieure 53.

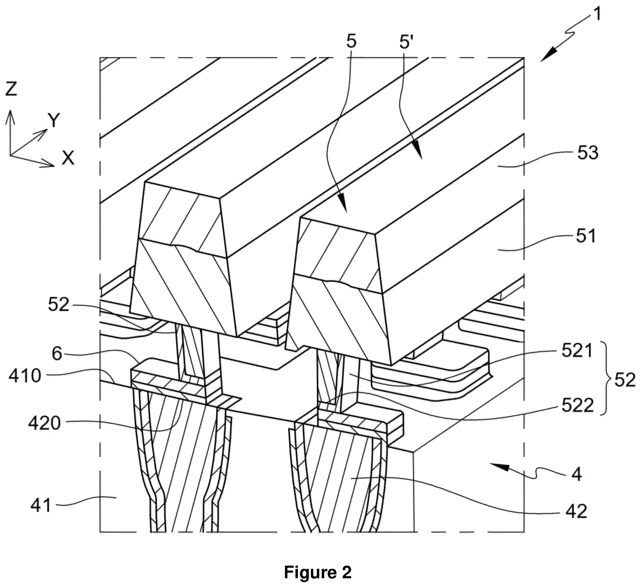

La figure 2 présente un deuxième mode de réalisation d'un circuit intégré 1 selon l'invention. Cette figure montre le circuit intégré 1 dans une perspective permettant d'observer la distribution des barrières de diffusion 6, arrangées selon une matrice de colonnes (s'étendant selon la direction Y) et de lignes (s'étendant selon la direction X). Chaque barrière de diffusion 6 s'étend, sous forme de couche fine, sur un via 42. Il peut en être déduit que les vias 42 du niveau de routage 4 sous-jacent sont également arrangés selon cette même matrice de colonnes et de lignes. Dans le cas où le niveau de routage 4 comprend des lignes plutôt que des via, les lignes peuvent s'étendre dans le substrat selon la direction X.

Les mémoires non volatiles 5, 5' de la figure 2 sont également arrangées selon la matrice de colonnes et de lignes, chaque mémoire se situant dans le prolongement d'un élément chauffant 52. À la différence du mode de réalisation des figures 1A et 1B, où les mémoires voisines 5, 5' d'une même ligne partagent une même première couche active 51, toutes les mémoires 5, 5' de la figure 2 arrangées selon une même colonne (c'est-à-dire selon la direction Y) partagent une même première couche active 51. Dans le mode de réalisation des figures 1A et 1B, il est dit que les mémoires 5, 5' forment, deux à deux, des « îlots mémoires », tandis que dans le mode de réalisation de la figure 2, il est dit que les mémoires 5, 5' forment, selon chaque colonne, des « colonnes mémoires » (ou des « lignes mémoires » si elles sont arrangées selon la direction X).

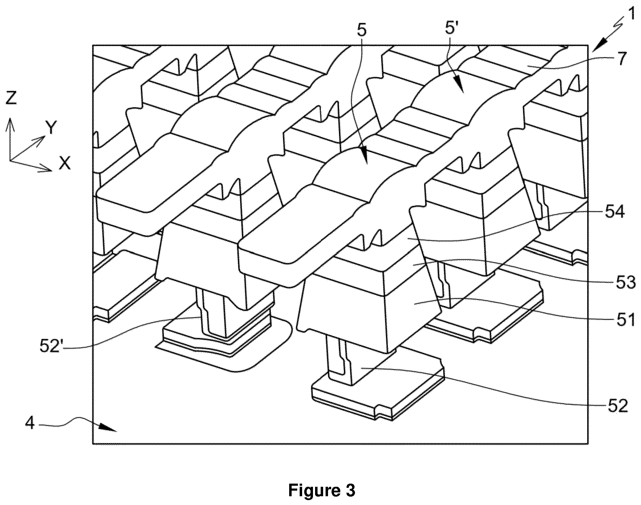

La figure 3 présente un troisième mode de réalisation d'un circuit 1 selon l'invention. À la différence des modes de réalisation des figures 1A, 1B et 2, les premières couches actives 51 de chaque mémoire 5, 5' sont distinctes les unes des autres. De la même manière, les électrodes supérieures 53 de chaque mémoire 5, 5' sont distinctes les unes des autres.

Le circuit 1 comprend également une pluralité de deuxièmes couches actives 54 s'étendant parallèlement à la surface supérieure 410 du substrat 41, électriquement connectées aux premières couches actives 51 en s'étendant contre chaque électrode supérieure 53. Cette deuxième couche active 54 joue par exemple le rôle d'élément de sélection, également appelé « sélecteur de mémoire ». Elle peut se comporter comme un commutateur ovonique à seuil, dit « OTS » pour « Ovonic Threshold Switching » en anglais. Pour cela, chaque deuxième couche active 54 comprend par exemple un alliage à base de Ge, Sb, Se, As, Si, Te, S ou Al, pouvant être dopé, tel que les alliages de GeSbSe, GeSe, AsSeSiGe, AsSe, SbSe, SiSe, AsTe, SiGeSe ou AlTe. La deuxième couche active 54 peut comprendre tout type de matériau lui permettant de fonctionner, selon des mécanismes internes différents, comme un sélecteur de mémoire.

Il est possible que l'OTS (i.e., la deuxième couche active) soit verticalement aligné avec la mémoire non volatile 5, 5'. Il est également ou alternativement possible que l'OTS (i.e., la deuxième couche active) soit cointégré à la mémoire non volatile correspondante.

L'électrode supérieure 53 entre les deux couches actives 51, 54 d'une mémoire 5, 5' permet d'améliorer le contact électrique entre ces deux couches 51, 54 pour rendre leur comportement reproductible et identique de mémoire à mémoire.

Dans la figure 3, chaque piste conductrice 7 est connectée aux mémoires 5, 5' d'une même colonne en s'étendant contre les deuxièmes couches actives 54 de chaque mémoire 5, 5'.

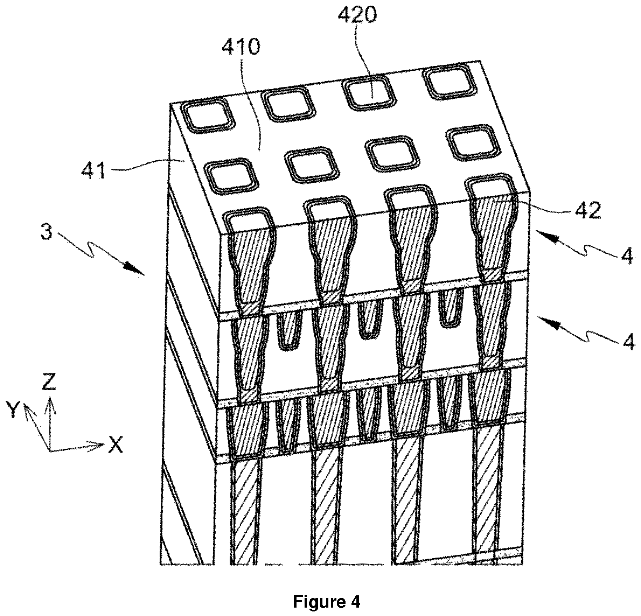

Les figures 4 à 18 présentent un premier mode de mise en oeuvre d'un procédé de fabrication d'une circuit intégré 1 selon l'invention.

La figure 4 présente une étape de fourniture d'un niveau de routage cuivre 4. Le niveau de routage 4 comprend un substrat 41 et une pluralité de via 42 en cuivre. Le substrat 41 présente une surface plane 410. Chaque via 42 traverse le substrat 41 de part en part et débouche sur la surface plane 410 du substrat 41 en exposant une surface de contact 420. Une planarisation physico-chimique, dite « CMP » pour « Chemical and Physical Planarisation » en anglais, peut permettre une mise à niveau de la surface plane 410 du substrat 41 et des surfaces de contact 420.

Les vias 42 du niveau de routage sont agencées selon une matrice de colonnes (selon la direction Y) et de lignes (selon la direction X).

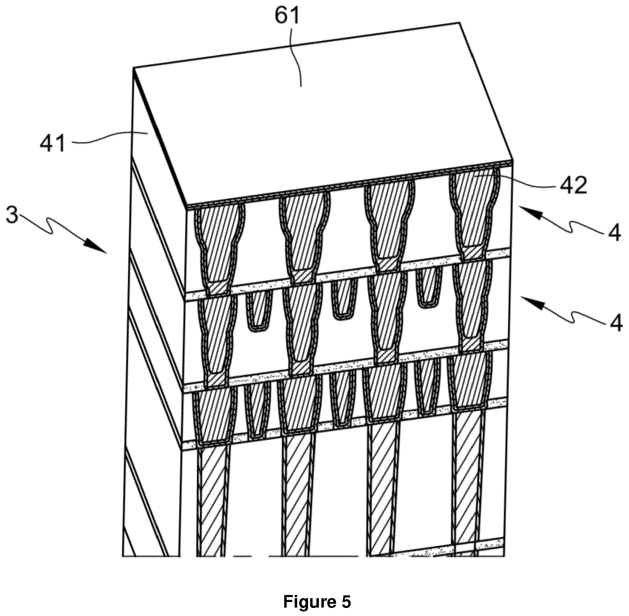

Les figures 5 à 18 présentent plusieurs étapes permettant de former une barrière de diffusion 6 sur chaque via 42. Elles présentent également, conjointement à la formation des barrières de diffusion 6, la formation des mémoires 5, 5'.

La figure 5 présente une étape de dépôt d'une couche 61 de tantale ou de titane ou de cobalt ou de leurs alliages. Il s'agit par exemple de matériaux dits « céramiques » (tels que les alliages TaN/Ta, TiN, TiC, TiSiN, TiSiCN, TiWN, TaN ou TaCN) ou de matériaux métalliques (par exemple à base de Co). Pour la suite de la description, il sera décrit une mise en oeuvre où un matériau dit « barrière » est déposé, faisant référence à l'un quelconque des matériaux à base de tantale ou de titane ou de cobalt ou de leurs alliages. Le matériau barrière est déposé sous forme de couche 61, dite « couche en matériau barrière ».

Une, plusieurs ou toutes les barrières de diffusion peuvent être de forme planaire, c'est-à-dire qu'elle sont former de façon à être de forme planaire, voire être totalement de forme planaire.

La couche en matériau barrière 61 déposée recouvre le substrat 41 et les surfaces de contact 420 des vias 42. Certains matériaux, tels que TaN, peuvent nécessiter le dépôt préliminaire d'une couche de TaN sur le substrat 41 et les vias 42, pour permettre le dépôt d'une couche homogène de Ta dans une phase cristalline adaptée.

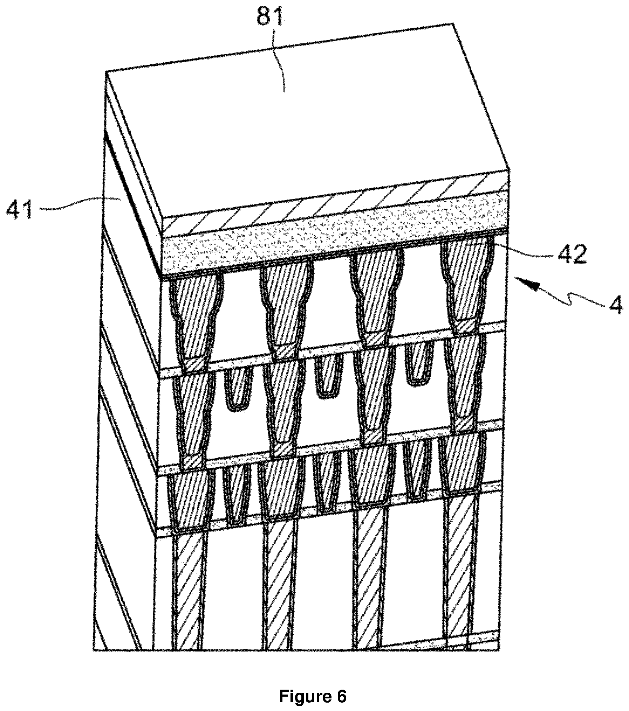

Les figures 6 à 18 présentent les étapes permettant, en parallèle de la formation des barrières de diffusion 6, de former les éléments chauffants 52. En particulier, les figures 6 à 10 présentent la formation d'une couche résistive 520, destinée à former au moins un élément chauffant 52 comprenant une ailette 521 s'étendant perpendiculairement à la couche 61 en matériau barrière et à l'aplomb de plusieurs vias 42 alignées selon une colonne. Selon ce mode de fabrication, l'élément chauffant 52 présente également un pied 522, s'étendant contre la couche 61 en matériau barrière, également à l'aplomb des mêmes vias 42 alignées selon la colonne.

Pour cela, la figure 6 présente une étape de dépôt d'une première couche 81 en matériau diélectrique, sur la couche en matériau barrière 61. La première couche diélectrique 81 comprend par exemple une sous-couche en SiN, s'étendant contre la couche en matériau barrière 61, et une sous-couche en SiO₂ s'étendant sur la couche en SiN.

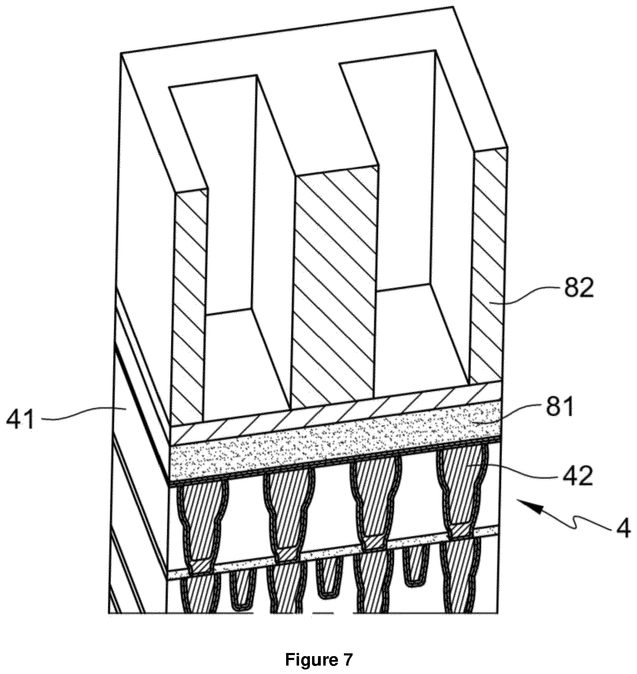

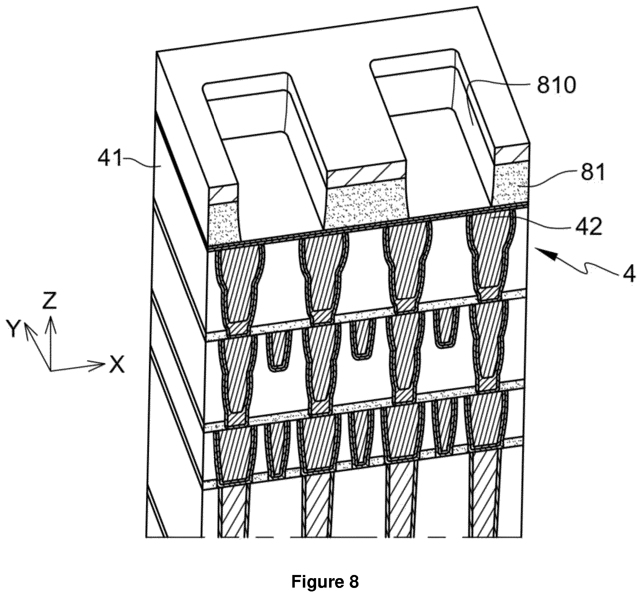

Les figures 7 et 8 présentent une étape de photolithographie et de gravure de la première couche diélectrique 81. La première couche diélectrique 81 est gravée à travers un masque de gravure 82 temporaire, avec arrêt sur la couche en matériau barrière 61, de manière à former des flancs 810 dans la première couche diélectrique 81. Chaque flanc 810 est disposé à l'aplomb d'au moins un via 42. En l'occurrence, dans l'exemple illustré, la première couche diélectrique 81 comprend quatre flancs 810, chacun d'eux s'étendant selon une colonne de vias 42 et à l'aplomb de ces vias 42. La première couche diélectrique 81 laisse également apparaître la couche en matériau barrière 61. Cette gravure peut être réalisée au moyen d'un plasma fluoré.

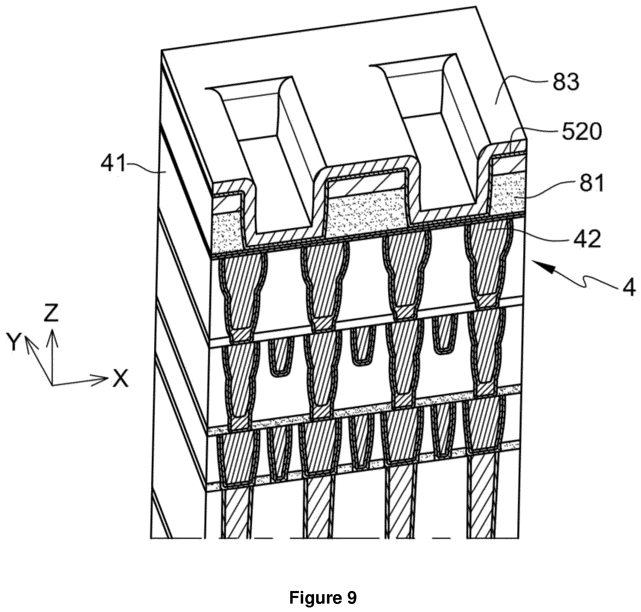

La figure 9 présente une étape de dépôt conforme d'une couche 520 en matériau résistif sur la première couche diélectrique 81, dont les flancs 810 de cette dernière, et les parties exposées de la couche en matériau barrière 61. La couche résistive 520 est par exemple réalisée à partir de TiN, de TiC, de TiSiN, de TiSiCN, de TiWN, de TaN ou de TaCN.

La figure 9 présente également le dépôt conforme d'une deuxième couche diélectrique 83, par exemple en SiN, sur la couche résistive 520. L'épaisseur de la deuxième couche diélectrique 83 permet de contrôler l'étendue du pied 522 de l'élément chauffant 52 selon la direction X. L'absence de la deuxième couche diélectrique 83 permet d'éviter l'apparition du pied 522. Toutefois, sa présence permet de protéger l'intégrité de l'ailette 521 lors de la gravure de la couche résistive 520.

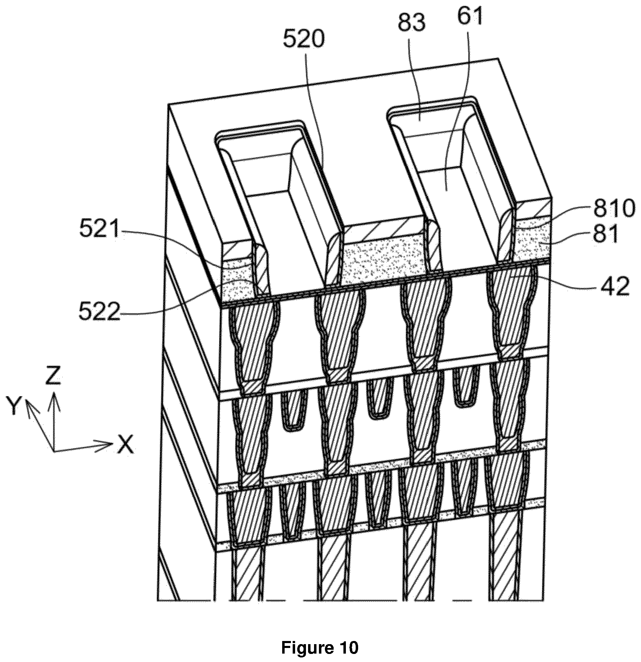

La figure 10 présente une étape de gravure anisotrope de la deuxième couche diélectrique 83 et de la couche résistive 520. Cette gravure est orientée perpendiculairement à la surface plane 410 du substrat 41 (autrement dit selon -Z) avec arrêt sur la couche 62 en matériau barrière. Elle peut être réalisée au moyen d'un plasma fluoré et chloré. Elle délimite notamment les ailettes 521 de la couche résistive 520, s'étendant contre le flanc 810 de la première couche diélectrique 81, et les pieds 522 de la couche résistive 520, protégés de la gravure anisotrope par une partie de la deuxième couche diélectrique 83 présentant une hauteur importante (la hauteur étant mesurée selon la direction Z).

Les portions 521, 522 de la couche résistive s'étendent ainsi à l'aplomb des vias 42 agencées selon une colonne.

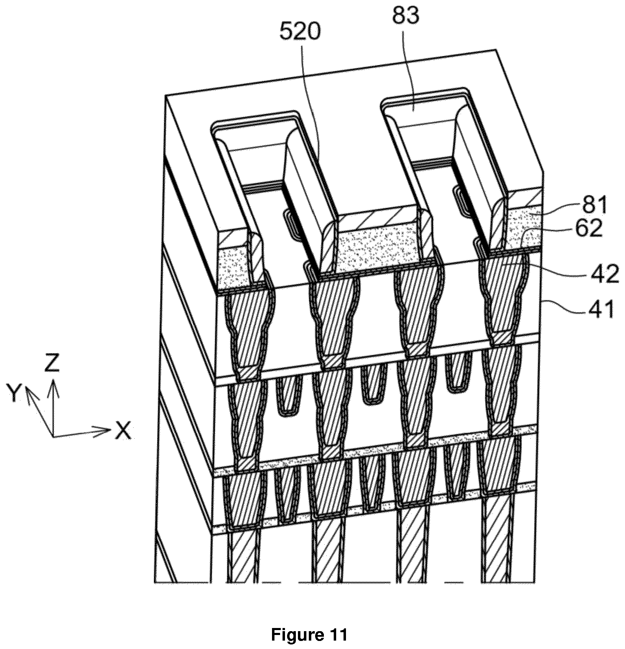

La figure 11 présente une gravure anisotrope de la couche 61 en matériau barrière avec arrêt sur le substrat 41. Cette gravure est réalisée en employant la première couche diélectrique 81, les parties restantes de la deuxième couche diélectrique 83 et les ailettes 521 de la couche résistive 520 comme masque de gravure. Cette gravure permet de délimiter des premières bandes 62 en matériau barrière dans la couche 61 en matériau barrière. Chaque bande 62 s'étend contre les surfaces de contact 420 de vias 42 s'étendant contre deux colonnes voisines. Typiquement, la gravure de la couche en matériau barrière est réalisée de sorte à former la ou les barrières de diffusion à la surface du contact.

Les gravures de la deuxième couche diélectrique 83, de la couche résistive 520 et de la couche 61 en matériau barrière peuvent être réalisées séquentiellement dans une même étape. La gravure de la couche 61 en matériau barrière peut également être réalisée au moyen d'un plasma fluoré et chloré.

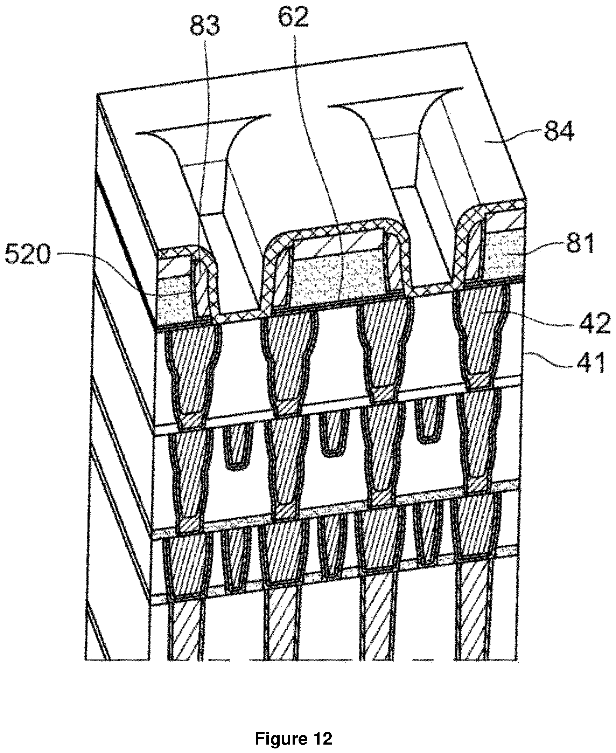

La figure 12 présente un dépôt conforme d'une troisième couche diélectrique 84, par exemple en SiN, sur l'ensemble des éléments. Cette troisième couche diélectrique 84 permet de passiver les pieds 522 de la couche résistive 520 (s'ils sont présents), destinés à former les pieds des éléments chauffants 52 des mémoires 5.

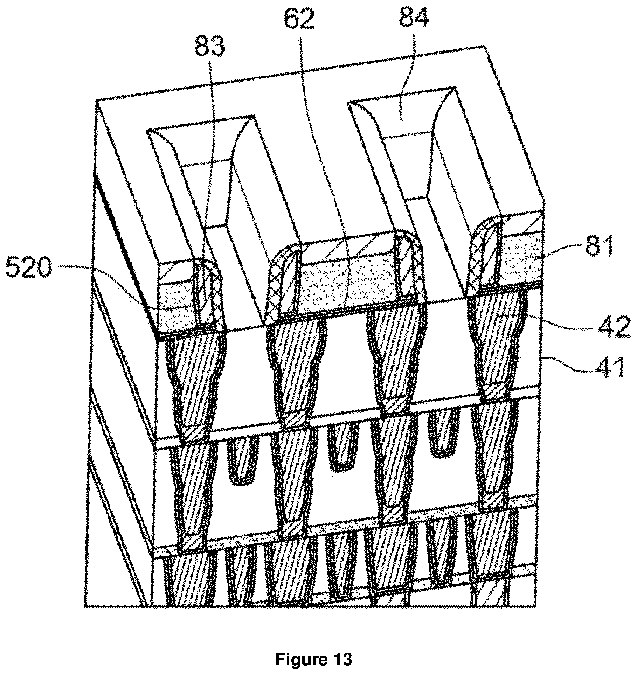

La figure 13 présente une gravure anisotrope, par exemple au moyen d'un plasma fluoré, de la troisième couche diélectrique 84 avec arrêt sur le substrat 41. Cette gravure retire les portions de la troisième couche diélectrique 84 s'étendant sur le substrat 41 et joignant deux pieds 522 de la couche résistive 520 voisins. Elle laisse en revanche des portions s'étendant perpendiculairement au plan, contre les parties restantes de la deuxième couche diélectrique 83 (elles-mêmes s'étendant contre les ailettes 521 de la couche résistive 520).

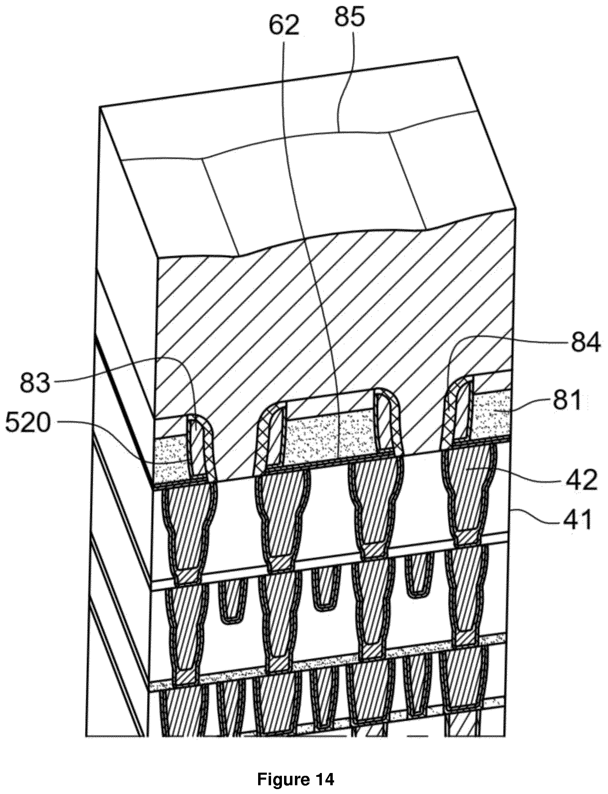

La figure 14 présente une étape de remplissage des cavités exposant le substrat 41. Le remplissage est par exemple réalisé par le dépôt d'un quatrième matériau diélectrique 85, par exemple en SiO₂, recouvrant l'ensemble des éléments.

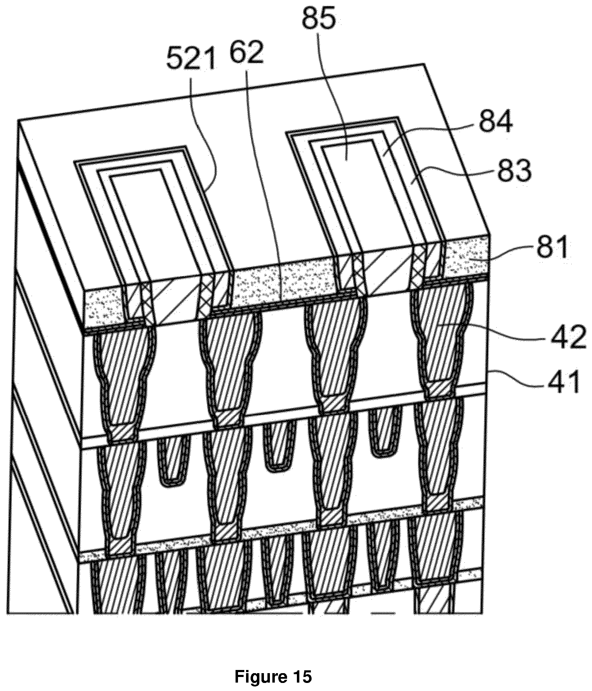

La figure 15 présente une étape de planarisation CMP permettant d'exposer une partie de chaque ailette 521 sur lesquels les premières couches actives 51 seront connectées.

L'intérêt de graver partiellement la troisième couche diélectrique 84, tel qu'illustré à la figure 13, est de retirer le matériau diélectrique en surface ce qui facilite la planarisation CMP de la figure 15. En effet, il est plus simple de planariser un oxyde tel que le SiO₂ plutôt qu'un diélectrique tel que le SiN. On obtient alors une planarisation CMP de l'oxyde qui soit sélective et avec arrêt sur SiN maitrisable et reproductible dans le sens d'un procédé industrialisable.

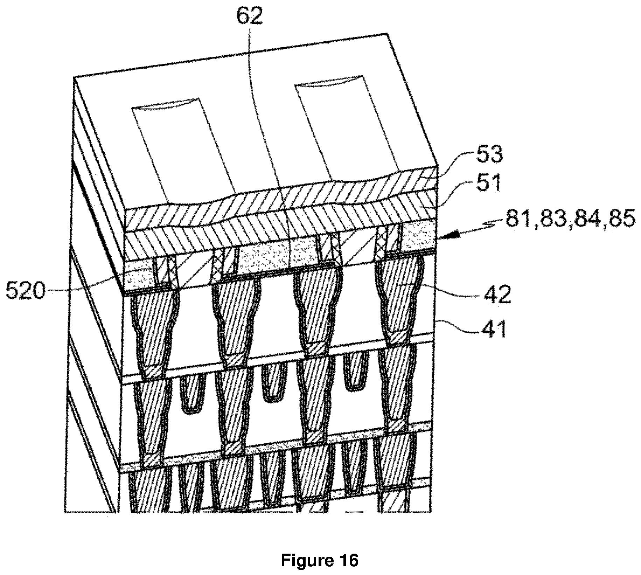

La figure 16 présente une étape de dépôt de la première couche active 51 contre les ailettes 521 et contre les couches diélectriques 81, 83, 84, 85 déposées précédemment. La première couche active 51 s'étend parallèlement à la surface supérieure 410 du substrat 41.

La figure 16 présente également une étape de dépôt d'une première couche métallique 53, destinée à former les électrodes supérieures, sur la première couche active 51.

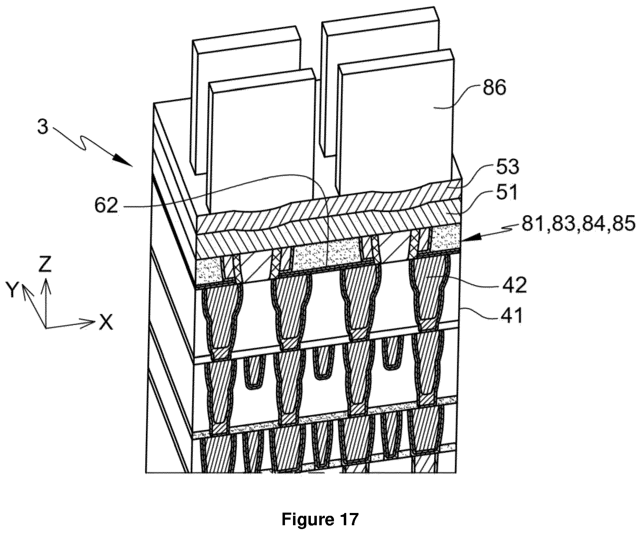

La figure 17 présente une étape de dépôt d'un deuxième masque de gravure 86 sur la première couche active 51 et la première couche métallique 53. Le deuxième masque de gravure 86 présente des îlots alignés sur les lignes et les colonnes de vias 42, c'est-à-dire selon les directions X et Y. Chaque îlot est disposé et orienté de manière à délimiter, après une gravure, les barrières de diffusion 6 et les mémoires 5, 5'.

Par exemple, chaque îlot est disposé et orienté de manière à recouvrir complètement, par projection selon Z, deux vias 46 voisins d'une même ligne. En revanche, chacun des îlots ne recouvre complètement, par projection selon Z, qu'un seul via 46 d'une même colonne. De cette manière, les îlots exposent des portions de la couche résistive 520 et des bandes 62 en matériau barrière à une gravure.

Les îlots du masque 86 sont également distants les uns des autres. En l'occurrence, les îlots d'une même ligne (alignés selon X) présentent une séparation à l'aplomb de chaque bande 62 en matériau barrière, exposant d'autres portions de celle-ci à une gravure.

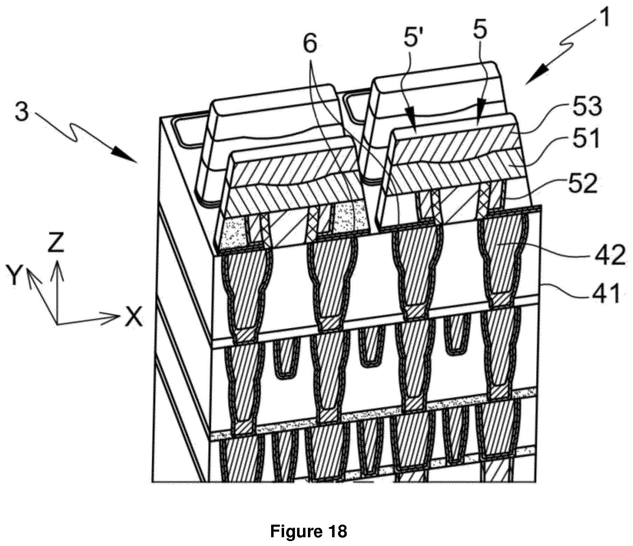

La figure 18 présente le résultat d'une étape de gravure anisotrope de :
- la première couche active 51 ;
- la première couche métallique 53 ;
- la couche résistive 520 ; et
- des bandes 62 en matériau barrière,
réalisée à travers le deuxième masque de gravure 86 et notamment à travers ses îlots, avec arrêt sur le substrat 41. Le circuit résultant correspond au circuit 1 illustré par les figures 1A et 1B.

La disposition des îlots du deuxième masque 86 permet de former, après gravure, les mémoires non volatiles 5, 5' telles qu'illustrées par les figures 1A et 1B. Chaque îlot du deuxième masque de gravure 86, recouvrant deux vias 42 d'une même ligne, permet de former des mémoires 5, 5' d'une même ligne dont les premières couches actives 51 et les électrodes supérieure 53 sont communes.

La gravure à travers le deuxième masque de gravure 86 permet également de sectionner la couche résistive 520 pour délimiter les éléments chauffants 52 dans le prolongement de chaque première couche active 51.

La combinaison des gravures à travers le premier masque (illustré à la figure 10, comprenant les première et deuxième couches diélectriques 81, 83 et la couche résistive 520) avec le deuxième masque 86 permet de délimiter chaque élément chauffant 52 et chaque barrière de diffusion 6 dans le prolongement l'une de l'autre.

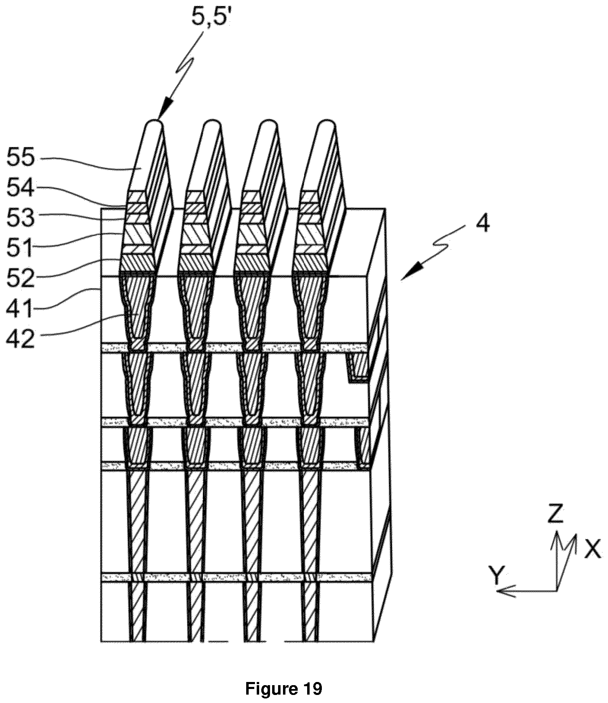

Les figures 19 à 22 présentent des étapes complémentaires pouvant être mise en oeuvre à partir de la cellule 1 obtenue par l'étape de la figure 18. Ces étapes complémentaires permettent de fabriquer un sélecteur, par exemple en OTS, pour chaque mémoire 5, 5" et connecter chaque sélecteur à une piste conductrice 7. Elles permettent notamment d'obtenir le circuit 1 de la figure 3.

La figure 19 présente la formation d'une deuxième couche active 54 sur chaque électrode supérieure 53. La deuxième couche active 54 est par exemple déposée, lors de l'étape de la figure 16, sur la première couche métallique 53. Ainsi la gravure de la figure 17 permet d'obtenir une pluralité de mémoires 5, 5' avec une première couche active 51, par exemple chargée de stocker une information, et une deuxième couche active 54, destinée à former un élément de sélection (dit aussi « sélecteur ») de la première couche active 51. Les matériaux indiqués précédemment peuvent être utilisés pour réaliser cette deuxième couche active 54. Afin de faciliter la connexion des mémoires 5, 5' aux pistes conductrices 7, une deuxième couche métallique 55 peut également être déposée sur la deuxième couche active 54.

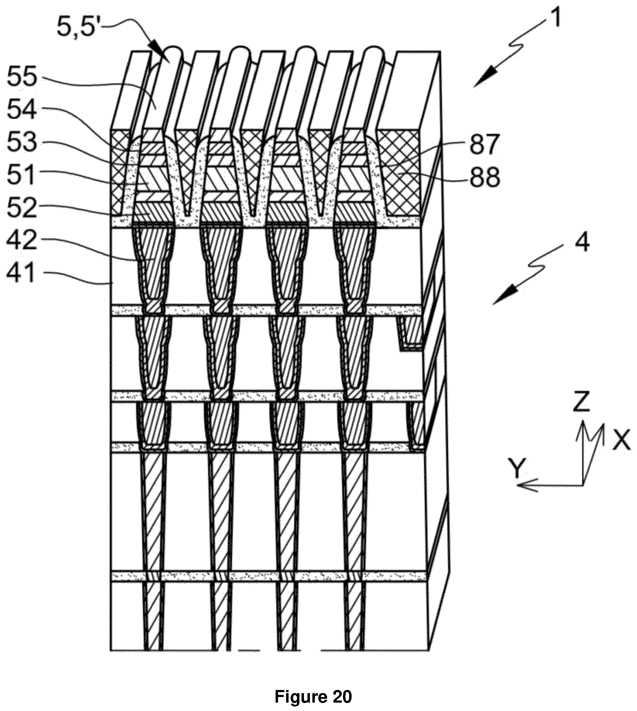

La figure 20 montre l'encapsulation des mémoires 5, 5' comprenant le dépôt conforme d'une cinquième couche diélectrique 87 contre les flancs de chaque mémoire 5, 5' et le remplissage des cavités laissées par l'encapsulation par une sixième couche diélectrique 88, par exemple en SiO₂. Le sommet des mémoires 5, 5' est libéré au moyen d'une étape de planarisation CMP avec arrêt sur le sommet des mémoires 5, 5', c'est-à-dire la deuxième couche métallique 55.

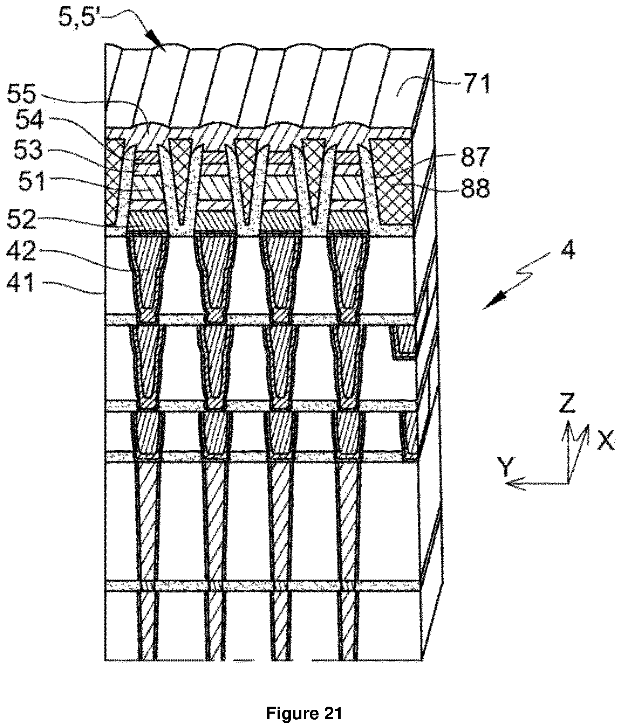

La figure 21 montre le dépôt d'une troisième couche métallique 71 permettant de réaliser les pistes conductrices 7.

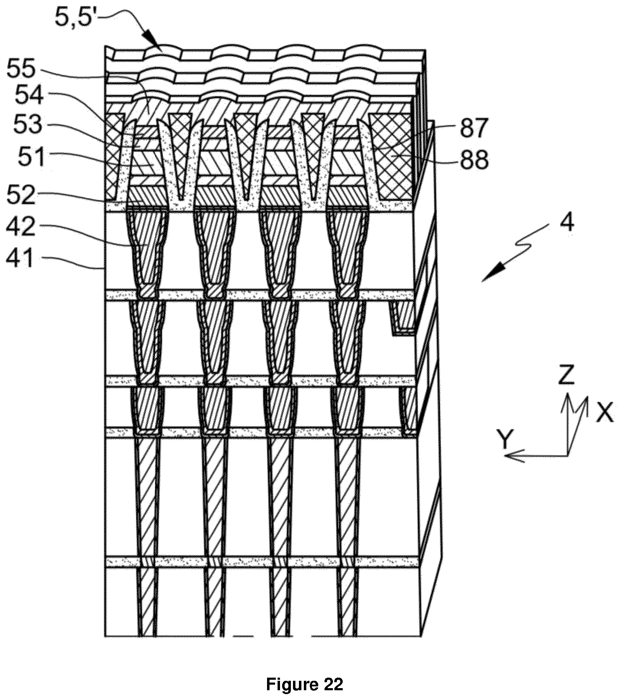

La figure 22 présente une étape de gravure de la troisième couche métallique 71 et des différentes couches 51, 52, 53, 54, 55 des mémoires 5, 5'. La gravure est réalisée à travers un troisième masque de gravure alignés sur les colonnes de vias 42, avec arrêt sur le substrat 41. Cette gravure sépare les mémoires 5, 5' les unes des autres (c'est-à-dire que les premières et deuxièmes couches 51, 54 sont distinctes), chacune étant connectée à une piste conductrice 7.

Une première variante de mise en oeuvre du procédé consiste à remplacer le dépôt et les gravures visant à former les barrières de diffusion 6 par une étape de croissance desdites barrières 6. La croissance des barrières comprend par exemple une étape de dépôt sélectif par rapport au substrat 41. Les matériaux utilisés pour réaliser le dépôt sélectif comprennent donc tout type de matériau à base de Ta, ou de Ti ou de Co et permettant un dépôt sélectif. Il s'agit par exemple des matériaux dits « céramiques » tels que présentés précédemment (par exemple TaN/Ta, TiN, TiC, TiSiN, TiSiCN, TiWN, TaN ou encore TaCN) ou des matériaux métalliques, tels que le titane ou le tantale ou le cobalt. Le dépôt sélectif d'un matériau compatible par rapport au substrat 41 permet ainsi de réaliser la croissance des barrières à partir de chaque surface de contact 420 des vias 42, débouchant sur le substrat 41. Il n'est donc plus nécessaire de recourir à une étape de gravure pour délimiter et aligner les barrières 6 avec les vias 42.

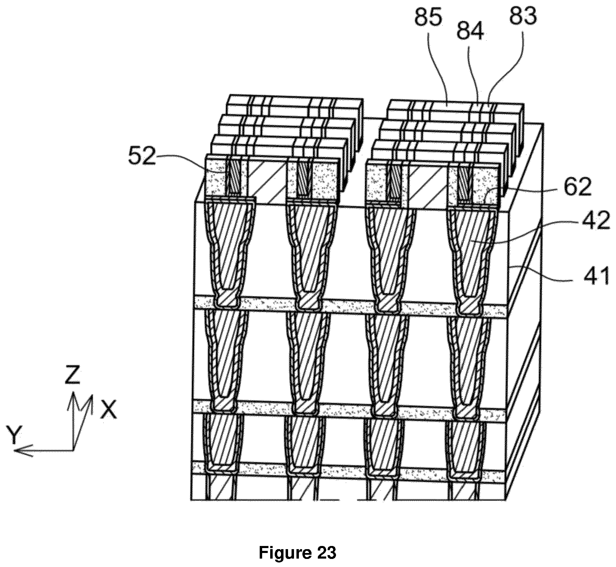

Les figures 23 à 25 présentent une variante de mise en oeuvre du procédé de fabrication, notamment des figures 16 à 18. Cette variante permet d'obtenir le circuit de la figure 2.

Avant de déposer la première couche active 51 et la première couche métallique 53, cette variante propose de graver l'empilement de la figure 15 à travers un masque de gravure, avec arrêt sur le substrat 41. Le résultat de la gravure est illustré par la figure 23. Elle permet de délimiter chaque élément chauffant 52 et chaque barrière de diffusion 6 dans le prolongement l'une de l'autre. Le masque de gravure employé pour réaliser la gravure est similaire au deuxième masque de gravure 86 illustré à la figure 17, comprenant notamment des îlots.

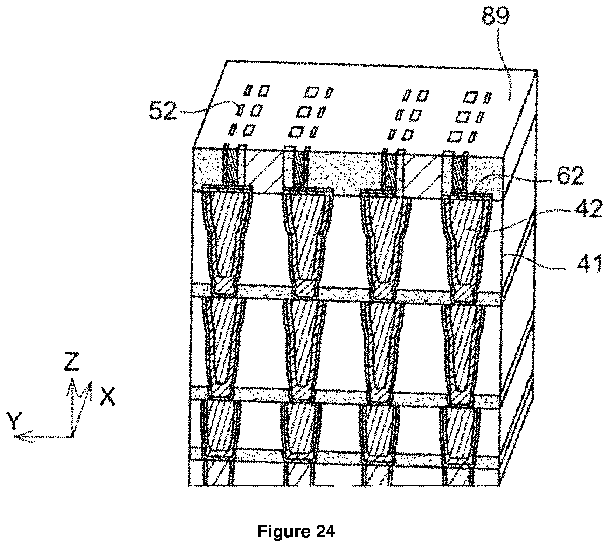

La figure 24 présente le résultat d'une étape de dépôt d'une septième couche diélectrique 89, par exemple en SiN, et d'une planarisation CMP avec arrêt au sommet des éléments chauffants 52.

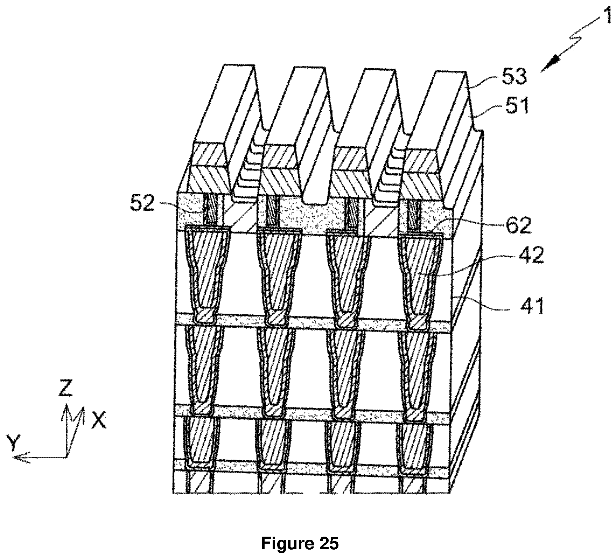

La figure 25 montre le circuit 1 obtenu à l'issu du dépôt d'une première couche active sur l'empilement de la figure 24 et de la gravure de cette dernière de manière à former des lignes de première couche active 51, s'étendant contre les éléments chauffants 52 d'une même ligne.

## Revendications

1. Circuit intégré (1) comprenant :
- un substrat (41) présentant une surface plane (410) ;
- au moins un via (42) ou une ligne, en cuivre, s'étendant dans le substrat (41) et débouchant sur la surface plane (410) du substrat (41) en exposant une surface (420) dite « surface de contact » ;
- au moins une mémoire non volatile (5, 5') comprenant :
- une première électrode (52), dite « élément chauffant » ;
- une deuxième électrode (53), dite « électrode supérieure » ; et
- une première couche active (51) entre l'élément chauffant (52) et l'électrode supérieure (53), électriquement connectée à l'électrode supérieure (53) et à l'élément chauffant (52),
le circuit intégré (1) étant **caractérisé en ce qu'**il comprend au moins une barrière de diffusion au cuivre (6) à base de tantale ou de titane ou de cobalt ou un de leurs alliages, ladite au moins une barrière de diffusion (6) s'étendant sous forme de couche contre au moins une partie de la surface de contact (420) dudit au moins un via (42) ou de ladite au moins une ligne, l'au moins une barrière de diffusion (6) étant totalement de forme planaire, l'élément chauffant (52) de ladite au moins une mémoire non volatile (5, 5') étant en contact avec la première couche active (51) de ladite au moins une mémoire non volatile (5, 5') et en contact avec ladite au moins une barrière de diffusion (6).

2. Circuit intégré (1) selon la revendication précédente, dans lequel, pour chaque mémoire (5, 5') non volatile, chaque élément chauffant (52) comprend une portion (521), dite « ailette », s'étendant perpendiculairement à la surface (410) du substrat (4) et comprenant une première extrémité (5211), en contact avec la première couche active (51) de ladite mémoire non volatile, et une deuxième extrémité (5212), en contact avec ladite au moins une barrière de diffusion (6).

3. Circuit intégré (1) selon l'une des revendications précédentes, dans lequel, chaque barrière de diffusion (6) s'étend contre la totalité de la surface de contact (420) dudit au moins un via (42) ou de ladite ligne en cuivre.

4. Circuit intégré (1) selon l'une des revendications précédentes, dans lequel chaque élément chauffant (52) comprend un matériau parmi : TiN, TiC, TiSiN, TiSiCN, TiWN, TaN et TaCN.

5. Circuit intégré (1) selon l'une des revendications précédentes, dans lequel la première couche active (51) de chaque mémoire volatile (5, 5') comprend un matériau chalcogénure.

6. Circuit intégré (1) selon l'une des revendications précédentes, comprenant :
- une pluralité de mémoires non volatiles (5, 5') ; et
- une pluralité de barrières de diffusion (6), distantes les unes des autres ;
- une pluralité de vias (42) en cuivre ou de lignes en cuivre, chaque via ou ligne s'étendant dans le substrat (41) et débouchant sur la surface (410) du substrat (41) en exposant une surface de contact (420), lesdites surfaces de contact (420) étant agencées selon une matrice,
chaque barrière de diffusion (6) s'étendant sous forme de couche contre au moins une partie de la surface de contact (420) d'un des vias (42) ou d'une des lignes, l'élément chauffant (52) de chaque mémoire non volatile (5, 5') étant connecté à l'une des barrières de diffusion (6).

7. Circuit intégré (1) selon l'une des revendications 1 à 6, dans lequel les premières couches actives (51) des différentes mémoires non volatiles (5, 5') sont isolées latéralement les unes des autres.

8. Circuit intégré (1) selon l'une des revendications 1 à 6, dans lequel une même première couche active (51) est continue et commune à au moins deux mémoires non-volatiles (5, 5'), ladite même première couche active (51) étant en contact avec chaque élément chauffant (52) desdites au moins deux mémoires non-volatiles (5, 5').

9. Circuit intégré (1) selon l'une des revendications précédentes, comprenant, un élément de sélection (54) associé à ladite au moins une mémoire non volatile (5, 5'), l'élément de sélection (54) étant un commutateur ovonique à seuil dit « OTS », l'OTS étant verticalement aligné avec la mémoire non volatile (5, 5').

10. Circuit intégré (1) selon l'une des revendications précédentes, dépourvu de via en tungstène ou de via métallique en contact avec ledit au moins un via (42) en cuivre ou ladite au moins une ligne en cuivre et l'élément chauffant (52) de ladite au moins une mémoire non volatile (5, 5').

11. Circuit intégré (1) selon l'une des revendications précédentes, dans lequel l'au moins une barrière de diffusion (6) est un bicouche planaire, le bicouche planaire comprenant du TaN en contact avec le via (42) ou la ligne, et comprenant du Ta au contact de l'élément chauffant.

12. Procédé de fabrication d'un circuit intégré (1) comprenant les étapes de :
- fournir :
- un substrat (41) présentant une surface plane (410) ; et
- au moins un via (42) ou au moins une ligne, en cuivre, s'étendant dans le substrat (41) et débouchant sur la surface plane (410) du substrat (41) en exposant une surface (420) dite « surface de contact »,
- former au moins une barrière de diffusion (6) au cuivre à base de tantale ou de titane ou de cobalt ou de leurs alliages, de sorte que ladite au moins une barrière de diffusion (6) s'étende sous forme de couche contre au moins une partie de la surface de contact (420) dudit au moins un via (42) ou de ladite au moins une ligne, l'au moins une barrière de diffusion étant totalement de forme planaire ;
- former au moins une mémoire non volatile (5, 5') comprenant :
- une première électrode (52), dite « élément chauffant », étant en contact avec ladite au moins une barrière de diffusion (6) ;
- une deuxième électrode (53), dite « électrode supérieure » ; et
- une première couche active (51) entre l'élément chauffant (52) et l'électrode supérieure (53), électriquement connectée à l'électrode supérieure (53) et en contact avec l'élément chauffant (52).

13. Procédé de fabrication selon la revendication 12, dans lequel la fabrication de chaque barrière de diffusion (6) comprend une étape de croissance de ladite barrière de diffusion (6) par dépôt sélectif de tantale ou de titane ou de cobalt ou leurs alliages sur la surface de contact (420) d'un via (42) en cuivre ou d'une ligne en cuivre.

14. Procédé de fabrication selon la revendication 12, dans lequel la fabrication de la barrière de diffusion (6) comprend les étapes de :
- déposer une couche (61) à base de tantale ou de titane ou de cobalt ou de leurs alliages, dite « couche en matériau barrière », sur la surface plane (410) du substrat (4) et la surface de contact (420) dudit au moins un via (42) ou de ladite au moins une ligne en cuivre ;
- graver la couche en matériau barrière (61) à travers au moins un masque de gravure (81, 521, 86), avec arrêt sur le substrat (41), de manière à former l'au moins une barrière de diffusion (6) à la surface de contact (420).

15. Procédé de fabrication selon la revendication précédente, dans lequel la formation de chaque mémoire non volatile (5, 5') comprend les étapes de :
- former, avant l'étape de gravure de la couche en matériau barrière (61), une première couche diélectrique (81) s'étendant sur la couche en matériau barrière (61), laissant libre au moins une portion de la couche barrière (61), ladite première couche diélectrique (81) comprenant au moins un flanc (810) s'étendant perpendiculairement à la surface plane (410) du substrat (41), à l'aplomb de la surface de contact (420) dudit au moins un via (42) ou de ladite au moins une ligne ;
- déposer une couche résistive (520) de manière conforme sur la première couche diélectrique (81) et sur ladite au moins une portion libre de la couche barrière (61) ;
- graver la couche résistive (520) de manière anisotrope, perpendiculairement à la surface plane du substrat (410), avec arrêt sur la couche barrière (61), de manière à laisser une portion (521) de la couche résistive (520), dite « ailette », s'étendant perpendiculairement à la surface plane (410) du substrat (41), depuis la couche barrière (61), contre le flanc (810) de la première couche diélectrique (81) et à l'aplomb de la surface de contact (420) dudit au moins un via (42) ou de ladite au moins une ligne ;
- graver la couche en matériau barrière (61) de manière anisotrope à travers un premier masque de gravure (81, 521), avec arrêt sur le substrat (41), le premier masque de gravure comprenant la première couche diélectrique (81) et l'ailette (521) ;
- graver l'ailette (521) et la couche en matériau barrière (61) de manière anisotrope à travers un deuxième masque de gravure (86), avec arrêt sur le substrat (41), de manière à délimiter chaque barrière de diffusion (6) à partir de la couche en matériau barrière (61), au niveau d'une partie de la surface de contact (420) dudit au moins un via (42) ou de ladite au moins une ligne, et de manière à délimiter chaque première électrode (52), dite « élément chauffant », à partir de l'ailette (521), dans le prolongement d'une barrière de diffusion (6).

16. Procédé de fabrication selon la revendication précédente, dans lequel la formation de chaque mémoire non volatile (5, 5') comprend les étapes de :
- déposer, avant la gravure de l'ailette (521) et de la couche en matériau barrière (61) à travers le deuxième masque de gravure (86), une première couche active (51) s'étendant parallèlement à la surface plane (410) du substrat (41) et au contact de chaque ailette (521) ;
- graver la première couche active (51) à travers le deuxième masque de gravure (86) de manière à délimiter la première couche active (51) dans le prolongement d'un élément chauffant (52) et d'une barrière de diffusion (6).

17. Procédé selon l'une des revendications 12 à 16, dans lequel l'au moins une barrière de diffusion (6) est gravée une première fois selon une première direction lors de la formation de l'élément chauffant (52), et une deuxième fois selon une deuxième direction, différente de la première direction, lors de la formation de l'électrode supérieure (53).
